(19) Europäisches Patentamt
European Patent Office
Office européen des brevets

(11) **EP 3 132 872 A1**

(12) **EUROPEAN PATENT APPLICATION**
published in accordance with Art. 153(4) EPC

(43) Date of publication:
**22.02.2017 Bulletin 2017/08**

(51) Int Cl.:
***B22F 1/00*** (2006.01)     ***B22F 1/02*** (2006.01)
***B23K 35/30*** (2006.01)     ***C04B 37/00*** (2006.01)

(21) Application number: **15780510.2**

(22) Date of filing: **11.03.2015**

(86) International application number:
**PCT/JP2015/001320**

(87) International publication number:
**WO 2015/159480 (22.10.2015 Gazette 2015/42)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **14.04.2014 JP 2014083114**

(71) Applicant: **Bando Chemical Industries, Ltd.
Kobe-shi, Hyogo 650-0047 (JP)**

(72) Inventors:
• **SHIMOYAMA, Kenji
Kobe-shi
Hyogo 650-0047 (JP)**
• **TAKESUE, Masafumi
Kobe-shi
Hyogo 650-0047 (JP)**

(74) Representative: **Gill, Stephen Charles et al
Mewburn Ellis LLP
City Tower
40 Basinghall Street
London EC2V 5DE (GB)**

(54) **BONDING COMPOSITION AND METAL BONDED BODY USING SAME**

(57)     Provided are: a bonding composition which is mainly composed of inorganic particles and is capable of providing a metal bonded body that has high shear strength and long-term reliability; and a metal bonded body using the bonding composition. The present invention relates to a bonding composition which contains inorganic particles and an organic component, and which is characterized in that the sulfur content in the bonding composition is 10% by atom or less relative to the total amount of the inorganic particles and the sulfur.

**Description**

TECHNICAL FIELD

The present invention relates to a bonding composition which is mainly composed of inorganic particles and a metal bonded body using the bonding composition, and more specifically relates to a bonding composition which is capable of providing a metal bonded body that has high shear strength and long-term reliability and a metal bonded body using the bonding composition.

BACHGROUND ARTS

In order to mechanically and/or electrically and/or thermally bond a metal component and another metal component, there have been used conventionally, a solder, a conductive adhesive, a silver paste, an anisotropically-conductive film, and the like. The conductive adhesive, silver paste, and anisotropically-conductive film are sometimes used when bonding not only the metal components but ceramic components, resin components. For example, there are bonding of a light-emitting element such as LED to a substrate, bonding of a semiconductor chip to a substrate, and further bonding of these substrates to a radiation member.

Among them, an adhesive, paste and film which contain the solder and a conductive filler made of a metal are used for bonding at a portion requiring an electric connection. In addition, since a metal generally has a high thermal conductivity, these paste and film which contain the solder and a conductive filler made of a metal may be used for increasing in heat dissipation.

To the contrary, for example, when an illumination device or a light-emitting device with high luminance is produced by using a light-emitting element such as LED, or when a semiconductor device is produced by using a semiconductor element that is referred to as a power device, and that performs highly efficient at a high temperature, a calorific value tends to increase. Although an efficiency of a device or an element is attempted to be improved for reducing heat generation, a sufficient result has not yet been obtained at this time, and the operating temperature of a device or an element is increased practically.

Further, from a viewpoint of prevention of a device from damage upon bonding, a bonding material that can ensure sufficient strength at a low bonding temperature (for example, at 300°C or lower) is in required. Therefore, with respect to the bonding material for bonding a device, an element or the like, it is required not only to lowering the bonding temperature, but also to give an enough thermal resistance that tolerates increase of the operating temperature due to action of the device after bonding and can maintain sufficient bonding strength, but conventional bonding materials cannot often sufficiently respond to this request. For example, the members are bonded by the solder via a process to heat the metal at its melting point or higher (re-flow process), but since the melting point is unique to the composition in general, when attempting the heat resistive temperature increase, the heating (bonding) temperature is also increased.

In addition, when several elements and substrates are bonded in the overlapping manner, it is necessary to provide heating steps for the number of the layers to be overlapped, and in order to prevent melting at the already-bonded portion, it is necessary to lower a melting point (bonding temperature) of a solder that is used for the next bonding, and further it is necessary that kinds of chemical composition of solder are required for the number of the layers to be overlapped, and thus handling becomes complicated.

On the other hand, in the conductive adhesive, silver paste and anisotropically-conductive film, members are bonded to each other by utilizing thermosetting of a contained epoxy resin and the like, but when the operating temperature of the obtained device or element is increased, there is a case that the resin component may be decomposed or deteriorated. For example, in Patent Literature 1 (Japanese Patent Laid-Open No. 2008-63688 ), though microparticles that are designed to obtain a higher bonding strength when members to be bonded are bonded by using a main material of the bonding member are proposed, the problems of decomposition and deterioration of the resin components upon increasing of the operating temperature have not been solved.

In addition, as a high temperature solder used at a high temperature, a solder containing lead has been used conventionally. Since lead is poisonous, a solder is drastically changed to a lead-free solder. However, since there is no other good substitute of the high temperature solder, the lead-containing solder is still used, but a bonding material with no lead is desired from the environmental point of view.

To the contrary, for example, as disclosed in Patent Literature 2 (Japanese Patent Laid-Open Application 2012-046779), recently, there has been developed a bonding material that contains a metal nano-particles mainly of a noble metal such as silver or gold. Specifically, by applying the bonding material between a first material to be bonded and a second material to be bonded and then sintering at a relatively low temperature (for example, 300°C or less), the first bonding material and teh second bonding material can be bonded.

PRIOR ART LITERATURE

Patent Literature

Patent Literature 1: Japanese Patent Laid-Open Application 2008-63688
Patent Literature 2: Japanese Patent Laid-Open Application 2012-046779

SUMMARY OF INVENTION

Problem to be Solved by the Invention

However, since the bonding layer prepared by sintering the bonding material by using the metal nano-particles has unavoidably fine lacks such as voids and the organic components, there is a problem that the high shear strength and long-term reliability of the bonding body cannot be ensured.

In light of the circumstances above, the objective of the present invention is to provide a bonding composition which is mainly composed of inorganic particles and a metal bonded body using the bonding composition, and more specifically relates to a bonding composition which is capable of providing a metal bonded body that has high shear strength and long-term reliability and a metal bonded body using the bonding composition.

Means for solving the problems

In order to accomplish the above objective, the result of the present inventor's intensive study as to the elements contained in the bonding composition, it has been found that the above objective can be accomplished effectively by appropriately controlling an amount of sulfur contained in the bonding composition and the bonding layer, and then the present invention has been completed.

Namely, the present invention can provide a bonding composition comprising an inorganic particle and an organic component, wherein a sulfur content in the bonding composition is 10 % by atom or less relative to the total amount of the inorganic particle and the organic component.

The sulfur atom may be one derived from the atmosphere and one derived from the materials used at the producing the bonding composition. Anyway, the sulfur tends to react with the inorganic particles to form sulfur compound on the surface of the inorganic particle. Since the sulfur compound formed on the surface of the inorganic particle may inhibit the sintering and fusion of the inorganic particles with each other at the sintering (bonding), it is not preferable from viewpoints of the high shear strength and long-term reliability of the bonding body. Here, when the sulfur content relative to the total amount of the inorganic particle and the sulfur in the bonding composition is 10 % by atom or less, the above formation of the sulfur compound can be inhibited. The sulfur content is preferably 8 % by atom, more preferably 4 % by atom or less. Further, in view of ensuring the bonding strength, shortening the production process, and ensuring the productivity, the sulfur content is preferably 0.35 % by atom or more.

The sulfur content in the bonding composition and the amount of atoms of the element which compose the inorganic particle can be measured by using, for example, the EDX (Energy Dispersive X-ray Spectroscopy) or the XPS (X-ray Photoelectron Spectroscopy).

In the bonding composition of the present invention, it is preferable that the aforementioned organic component adheres on the at least a part of the surface of the inorganic particle (namely, at least a part of the surface of the inorganic particle is covered with an organic protective layer composed of the aforementioned organic component), and the organic component (organic protective layer) contains an amine. In order to restore the inorganic particle having a nano-meter size which shows an ability of melting point depression, it is necessary to cover at least a part of the surface of the inorganic particle. Here, since the functional group of the amine can adsorb on the surface of the inorganic particle at an appropriate strength, it is suitably used as the organic protective layer.

In the bonding composition of the present invention, a mass loss ratio when heating from a room temperature to 500°C at a temperature elevating rate of 10 °C/min in an atmospheric circumstance is preferably less than 25 % by mass, more preferably less than 20 % by mass. When the mass loss ratio is less than 25 %, since an amount of volatile organic substance becomes small, and a void generated in the bonding layer is also little, the fused inorganic particles can easily be sintered and fused at a high density.

In the bonding composition of the present invention, it is preferable that the inorganic particle contains at least one metal selected from the group consisting of gold, silver, copper and platinum, and it is preferable that an average particle size of the inorganic particle is 1 to 100 nm. Furthermore, from the viewpoints that the surface ratio (relative surface area) becomes large, and thus, the contents of the inorganic substance and organic substance to ensure the bonding strength, and also the ability of melting point depression can be ensured, it is preferable that the average particle size of the inorganic particle is 2 to 95 nm. Here, the average particle size of the inorganic particle can be measured by a dynamic light scattering method, a small angle X-ray scattering method, and the like. As the other measuring method, there is a method where an authentic mean of 50 to 100 particles is calculated from photograph taken by using a scanning electron microscopy or a transmission electron microscopy.

According to the present invention, there can be provided a bonded body which comprises a first member to be bonded, a bonding layer, and a second member to be bonded, the first member to be bonded and the second member to be bonded is bonded by the bonding layer, and the bonding layer is composed of a metal having a sulfur content of 15 % by atom or less.

Here, the above sulfur content is preferably 9 % by atom or less. Further, in view of ensuring the bonding strength, shortening the production process, and ensuring the productivity, the sulfur content is preferably 0.35 % by atom or more. Each of the above first member to be bonded and the second member to be bonded may be composed of metal or ceramics, or may be composed of ceramics that a metal is plated on the surface.

As is in the same as the aforementioned bonding composition, the sulfur content in the bonding layer and the amount of atoms of the element which compose the inorganic particle can be measured by using, for example, the EDX (Energy Dispersive X-ray Spectroscopy) or the XPS (X-ray Photoelectron Spectroscopy).

Effect of the invention

The present invention can provide a bonding composition which is mainly composed of inorganic particles and a metal bonded body using the bonding composition, which is capable of obtaining a metal bonded body that has high shear strength and long-term reliability.

Means for Solving the Problem

Hereafter, one preferred embodiment of the bonding composition and the metal bonded body using the composition of the present invention will be explained in detail. Furthermore, the description below merely indicates one embodiment of the present invention, and the present invention shall not be limited to these, and redundant descriptions may be omitted.

(1) Bonding composition

The bonding composition according to the present embodiment is a bonding composition which contains an inorganic particle and an organic component as a main component and a side component, respectively. In the following, each component of the bonding composition is explained.

(1-1) Inorganic particles

Though the inorganic particles of the bonding composition according to the present embodiment are not particularly limited, since conductivity of a bonding layer obtained by using the bonding composition according to the present embodiment can be improved, it is preferable to be metal where ionization tendency is smaller (nobler) than zinc.

Examples of the metal include at least one of gold, silver, copper, nickel, bismuth, tin, iron, and platinum group elements such as ruthenium, rhodium, palladium, osmium, iridium, and platinum. As the metal, at least one of metal selected from the group consisting of gold, silver, copper, nickel, bismuth, tin and the platinum group is preferable, and more preferable is copper or a metal where its ionization tendency is smaller (nobler) than copper, i.e., at least one selected from the group consisting of gold, platinum, silver and copper.

These metals may be used alone or in combination of two or more, and as a method for combination, there is a case of using alloy particles containing a plurality of metals, or a case of using metal particles having a core-shell structure or a multilayered structure.

For example, when silver particles are used for the inorganic particles of the bonding composition, electroconductivity of the adhered layer formed by using the bonding composition according to the present embodiment becomes excellent, but in light of the problem of migration, it can become difficult for the migration to occur by using the bonding composition made of silver and other metals. As "other metals", metals where its ionization series above is nobler than hydrogen, i.e., gold, copper, platinum and palladium are preferable.

An average particle size of the inorganic particles in the bonding composition according to the present embodiment is not particularly limited as long within the range that does not impair the effect of the present invention, and a nano meter size where a melting point depression is caused in the metal is preferable, and more preferable is 1 to 100 nm. When the average particle size of the metal particles used as the inorganic particle is 1 nm or more, the boning composition that can form an excellent bonding layer is obtained, and the metal particle manufacturing will not cause increase in cost, and is practical. Further, when 100 nm or less, it is not ready to change dispersibility of the metal particles with laps of time, and is preferable.

Furthermore, it may be possible to use metal particles of micron meter size in addition to the above metal particles of nano meter size. In this case, the bonding is accomplished by depressing the melting point of the metal particles of nano meter size around the metal particles of micron meter size.

Herein, the average particle size of the inorganic particles in the bonding composition can be measured with a dynamic light scattering method, a small-angle X-ray scattering method or a wide-angle X-ray diffraction method. In order to show depression of the melting point of the metal particles with a nano meter size, a crystallite diameter obtained with the X-ray diffraction method is suitable. For example, in the wide-angle X-ray diffraction method, to be more specific, the particle size can be measured within the range where $2\theta$ is 30 ° to 80 ° with the diffraction method using RINT-Ultima III available from Rigaku Corporation. In this case, samples should be measured by thinning so as to be a flat surface on a glass plate with approximately 0.1 to 1 mm in depth of a concave portion in the center portion.

Further, the crystallite diameter (D) calculated by substituting a half bandwidth of obtained diffraction spectrum using JADE available from Rigaku Corporation into the Scherrer equation should be regarded as the average particle size.

$$D = K\lambda / B \cos\theta$$

Herein, K: Scherrer constant (0.9), $\lambda$: wavelength of X-ray, B: half bandwidth of diffraction line, $\theta$: Bragg angle.

It is preferable that the inorganic particles in the bonding composition according to the present embodiment do not contain particles that are converted to metal by the thermal decomposition. For example, when containing particles which are decomposed by heating to become a metal such as silver oxide or silver carbonate, since a gas such as oxygen or carbon dioxide and a metal are yielded upon the decomposition of the particles, the volume shrinkage becomes large. Since the volume shrinkage makes the bonding without pressure difficult, it is preferable that the particles that are converted to metal by the thermal decomposition is not used as the inorganic particles in the bonding composition according to the present embodiment.

(1-2) Organic component adhered at least onto surfaces of inorganic particles (Organic protective layer)

In the bonding composition according to the present embodiment, the organic component adhered at least onto a part of surfaces of the inorganic particles forms a so-called organic protective layer, and substantially constitutes the metal colloid particles along with the metal particles as a so-called dispersant. It is a concept that the organic component does not include an organic substance where its trace amount is adhered onto the metal particles and the like, such as a trace of an organic substance contained in metal initially as an impurity, a trace of an organic substance where it is mixed during the manufacturing process and is adhered onto a metallic component, a residual reducing agent or residual dispersant that could not be removed during the cleaning process. Furthermore, "trace amount" above specifically indicates less than 1 % by mass in the metal colloid particles.

The above organic component is an organic substance which can prevent the metal particles from agglomeration by adhering to the metal particles, and can form the metal colloid particles, and is preferably configured by an alkylamine and a polymer dispersant. By adhering the polymer dispersant to at least a part of the metal particles in an appropriate amount, dispersibility of the metal particles can be maintained without missing low temperature sintering property. The morphology of adhering or coating is not particularly defined, but in the present embodiment, the organic component is preferably contains an amine from viewpoints of dispersibility and conductivity. It is assumed that the amine is adsorbed at an appropriate strength via its functional group to the surfaces of the metal particles to prevent the contact of the metal particles with each other, which contributes the stability of the metal particles during storage, and when heated, by moving and/or volatilizing form the surface of the metal particles, fusion of the metal particles with each other and bonding of the metal particles to the substrate are accelerated.

The amines used herein is not particularly limited, and include an amine having 2 to 20 carbon atoms, for example, an alkylamine (linear alkylamine or may have an side chain) such as oleylamine, butylamine, pentylamine, hexylamine, hexylamine; a cycloalkylamine such as cyclopentylamine or cyclohexylamine; a primary amine such as allylamine, e.g. aniline; a secondary amine such as dipropylamine, dibutylamine, piperidine or hexamethyleneimine; and tertiary amine such as tripropylamine, dimethylpropanediamine, cyclohexyldimethylamine, pyridine or quinoline, octylamine, and the like. The amine is not limited to a linear type, and may have a side chain in order to control a temperature of volatilization. It is seemed that, when those organic component is chemically or physically bonded to the metal particles, the organic component may be converted to an anion or a cation, and in the present embodiment, the above organic components include such an ion or complex derived from the organic components.

The above amine may be a compound containing a functional group other than amine, such as a hydroxyl group, a carboxyl group, an alkoxy group, a carbonyl group, an ester group or a mercapto group. Further, the amine may be used alone or in combination of two or more. In addition, a boiling point at a normal pressure is preferably 300°C or less, further preferably 250°C or less.

The bonding composition according to the present embodiment may contain a carboxylic acid in addition to the amine within the scope that does not impair the effect of the present invention. In the carboxylic acid, the carboxyl group in one molecule has a relatively high polarity to generate interaction due to hydrogen bond, and the remaining part other than the functional group shows a relatively low polarity. Further, the carboxyl group tends to show acidic property. In addition, when the carboxylic acid is localized (adhered) to at least a part of the surface of the metal particles (namely, at least a part of the surface of the metal particles being covered with) in the bonding composition according to the present embodiment, it is possible to make the organic component and the metal particles affinity enough to prevent the metal particles from coagulation (enhancing dispersibility).

As the carboxylic acid, a compound having at least one carboxyl group can be broadly used, and example include formic acid, oxalic acid, acetic acid, hexane acid, acrylic acid, octylic acid, oleic acid and the like. A carboxyl group in a part of the carboxylic acid may form a salt with a metallic ion. Furthermore, as to the metal ion, two or more of metal ions may be contained.

The carboxylic acid may be a compound containing a functional group other than carboxyl group such as amino group, hydroxyl group, an alkoxy group, carbonyl group, an ester group or mercapto group. In this case, the number of carboxyl groups is preferably more than the number of functional groups other than carboxyl groups. Further, the carboxylic acid may be used alone, respectively, or in combination of two or more. In addition, it is preferable that a boiling point at a normal temperature is preferably 300 °C or less, further preferably 250 °C or less. Further, an amine and a carboxylic acid form an amide. Therefore, since the amide group is appropriately adsorbed on the surface of the silver particle, the amide group may be contained in the organic component.

As the above polymer dispersant, any commercial polymer dispersant can be used. Examples of the commercially available polymer dispersant include include SOLSPERSE 11200, SOLSPERSE 13940, SOLSPERSE 16000, SOLSPERSE 17000, SOLSPERSE 18000, SOLSPERSE 20000, SOLSPERSE 24000, SOLSPERSE 26000, SOLSPERSE 27000 and SOLSPERSE 28000 (available from Lubrizol Japan Corporation); DISPERBYK 142, DISPERBYK 160, DISPERBYK 161, DISPERBYK 162, DISPERBYK 163, DISPERBYK 166, DISPERBYK 170, DISPERBYK 180, DISPERBYK 182, DISPERBYK 184, DISPERBYK 190 and DISPERBYK 2155 (available from BYK Japan KK); EFKA-46, EFKA-47, EFKA-48 and EFKA-49 (available from EFKA Chemicals); Polymer 100, Polymer 120, Polymer 150, Polymer 400, Polymer 401, Polymer 402, Polymer 403, Polymer 450, Polymer 451, Polymer 452, Polymer 453 (available from EFKA Chemicals); Ajisper PB711, Ajisper PA111, Ajisper PB811 and Ajisper PW911 (available from AJINOMOTO Co., Ltd.); Flowlen DOPA-15B, Flowlen DOPA-22, Flowlen DOPA-17, Flowlen TG-730W, Flowlen G-700 and Flowlen TG-720W (available from KYOEISHA CHEMICAL Co., Ltd.), and the like. Among them, SOLSPERSE 11200, SOLSPERSE 13940, SOLSPERSE 16000, SOLSPERSE 17000, SOLSPERSE 18000, SOLSPERSE 28000, DISPERBYK 142 or DISPERBYK 2155 is preferable from the viewpoint of low-temperature sinterability and dispersing stability.

A content of the polymer dispersant is preferably 0.1 to 15 % by mass. When the content of the polymer dispersant is 0.1 % or more, the dispersibility of the obtained composition for bonding becomes better, but when the content is too larger, the bonding property becomes worse. From this point of view, the content of the polymer dispersant is more preferably 0.2 to 5 % by mass, further preferably 0.3 to 4 % by mass.

The content of the organic component in the metal colloid in the bonding composition of the present embodiment is preferably 0.5 to 50 % by mass. When the content of the organic component is 0.5 % by mass or more, the storage stability of the obtained composition for metal bonding tends to be better, and when 50 % by mass or less, the conductivity of the composition for metal bonding tends to be better. The content of the organic component is more preferably 1 to 30 % by mass, further preferably 2 to 15 % by mass.

As a composition ratio (mass) in case of using in combination of the amine and the carboxylic acid, it can be optionally selected within the range of 1/99 to 99/1, and is preferably 20/80 to 98/2, further preferably 30/70 to 97/3. Furthermore, for the amine or carboxylic acid, several kinds of amines or carboxylic acids may be used, respectively.

Examples of the unsaturated hydrocarbon contained in the bonding composition according to the present embodiment include ethylene, acetylene, benzene, acetone, 1-hexene, 1-octene, 4-vinylcyclohexene, cyclohexanone, a terpene-based alcohol, allyl alcohol, oleyl alcohol, 2-paltoleic acid, petroselinic acid, oleic acid, elaidic acid, thiocyanic acid, ricinoleic acid, linolic acid, linoekaidic acid, linoleic acid, arachidonic acid, acrylic acid, methacrylic acid, gallic acid, salicylic acid, and the like.

Among them, an unsaturated hydrocarbon having hydroxyl group is preferable. The hydroxyl group is easy to coordinate with the surface of the metal particles to inhibit the coagulation of the metal particles. Examples of the unsaturated hydrocarbon having hydroxyl group include a terpene-based alcohol, allyl alcohol, oleyl alcohol, thiocyanic acid, ricinoleic acid, gallic acid, salicylic acid, and the like. Preferable is an unsaturated fatty acid having hydroxyl group such as thiocyanic acid, ricinoleic acid, gallic acid, salicylic acid, and the like.

The above unsaturated hydrocarbon is preferably ricinoleic acid. Ricinoleic acid has carboxyl group and hydroxyl group, and adsorbs on the surface of the metal particles to disperse the metal particles uniformly and accelerates the fusion of the metal particles.

In the bonding composition of the present embodiment, in addition to the components above, within the scope that does not impair the effect of the present invention, in order to add functions such as appropriate viscosity, adhesiveness, drying characteristics or printability, according to purpose for uses, optional components such as a dispersing medium, an oligomer component that fulfills, for example, a role of binder, a resin component, an organic solvent (a portion of solid may be dissolved or dispersed), a surfactant, a thickener or a surface tension adjuster may be added. Such optional components are not particularly limited.

As the dispersing medium among the optional components, various components are usable within the scope that does not impair the effect of the present invention, and examples include a hydrocarbon, an alcohol and the like.

Examples of the hydrocarbon include an aliphatic hydrocarbon, a cyclic hydrocarbon, an alicyclic hydrocarbon and the like, and they may be used alone, respectively, or in combination of two or more.

Examples of the aliphatic hydrocarbon include a saturated or unsaturated aliphatic hydrocarbon such as tetradecane, octadecane, heptamethylnonane, tetramethylpentadecane, hexane, heptan, octane, nonane, decane, tridecane, methylpentane, normal paraffin or isoparaffin, and the like.

Examples of the cyclic hydrocarbon include toluene, xylene and the like.

Further, examples of the alicyclic hydrocarbon include limonene such as kautschin, cajeputen, cinene or orange flavor, dipentene, terpinene (also referred to as terpinene), nesol, terpinolene (also referred to as terpinolene), phellandrene, menthadiene, terebene, dihydrocymene, moslene, isoterpinene (also referred to as isoterpinene), crithmene, oilimene, pinene, terebine, menthane, pinane, terpene, cyclohexane, and the like.

Further, the alcohol is a compound containing one or more OH groups in the molecular structure, and examples include an aliphatic alcohol, a cyclic alcohol and an alicyclic alcohol, and they can be used alone, respectively, or in combination of two or more. Further, a part of the OH groups may be converted to an acetoxy group or the like within a scope that does not impair the effect of the present invention.

Examples of the aliphatic alcohol include a saturated or unsaturated C6-30aliphatic alcohol such as heptanol, octanol (such as 1-octanol, 2-octanol or 3-octanol), decanol (such as 1-decanol), lauryl alcohol, tetradecyl alcohol, cetyl alcohol, 2-ethyl-1-hexanol, octadecyl alcohol, hexadecenol or oleyl alcohol.

Examples of the cyclic alcohol include cresol, eugenol and the like.

Further, examples of the alicyclic alcohol include a cycloalkanol such as cyclohexanol; a terpene alcohol (monoterpene alcohol, or the like) such as terpineol (including $\alpha$, ß and $\gamma$ isomers, or any mixture thereof) or dihydroterpene; dihydroterpineol; myrtenol; sobrerol; menthol; carveol; perillyl alcohol; pinocarveol; sobrerol; verbenol and the like.

The content in case of containing a dispersing medium in the bonding composition according to the present embodiment should be adjusted according to desired characteristics such as viscosity, and the content of the dispersion medium in the composition for bonding is preferably 1 to 30 % by mass. When the content of the dispersing medium is 1 to 30 % by mass, an effect to adjust the viscosity can be obtained within the range that is easy to operate as a composition for bonding. The content of the dispersing medium is more preferably 1 to 20 % by mass, further preferably 1 to 15 % by mass.

Examples of the resin component include a polyester-based resin, a polyurethane-based resin such as a blocked polyisocyanate, a polyacrylate-based resin, a polyacrylamide-based resin, a polyether-based resin, a melamine-based resin, a terpene-based resin and the like, and these can be used alone, respectively, or in combination of two or more.

Examples of the organic solvent include, excepting the ones exemplified as the dispersing media, methyl alcohol, ethyl alcohol, n-propylalcohol, 2-propyl alcohol, 1,3-propanediol, 1,2-propanediol, 1,4-butanediol, 1,2,6-hexantril, 1-ethoxy-2-propanol, 2-butoxyethanol, ethylene glycol, diethylene glycol, triethylene glycol, polyethylene glycol having a weight-average molecular weight within the range of 200 or more and 1,000 or less, propylene glycol, dipropylene glycol, tripropylene glycol, polypropylene glycol having weight-average molecular weight within the range of 300 or more and 1,000 or less, N,N-dimethylformamide, dimethylsulfoxide, N-methyl-2-pyrrolidone, N,N-dimethylacetamide, glycerin, acetone and the like, and these can be used alone, respectively, or in combination of two or more.

Examples of the thickener include a clay mineral such as clay, bentonite or hectorite; an emulsion such as a polyester-based emulsion resin, an acrylic-based emulsion resin, a polyurethane-based emulsion resin or a blocked isocyanate; a cellulose derivative such as methyl cellulose, carboxymethyl cellulose, hydroxyethyl cellulose, hydroxypropyl cellulose, hydroxypropyl methylcellulose; a polysaccharide such as xanthane gum or guar gum, and the like, and these can be used alone, respectively, or in combination of two or more.

Further, a surfactant which is different from the above organic components may be added. In a multicomponent solvent-system metal colloid dispersion, roughness of coating surface due to a difference in a volatile rate upon drying and bias of solid content are easily happened. These disadvantages are controlled by adding a surfactant into the composition for bonding of the present embodiment, and a composition for bonding that can form a uniform conductive coating film can be obtained.

The surfactant being usable in the present embodiment is not particularly limited, but any of an anionic surfactant, a cationic surfactant and a nonionic surfactant are usable, and includes, for example, an alkyl benzene sulfonate, a quaternary ammonium salt and the like. Since an effect can be obtained with a small additive amount, a fluorine-based surfactant is preferable.

As the method for adjusting the amount of the organic component within a predetermined range, adjustment by heating is simpler. Further, the amount of the organic component to be added on the occasion of producing metal particles can be adjusted. Cleaning conditions and the number of times after the metal particle adjustment may be changed. Heating can be conducted with an oven or an evaporator, and it can be conducted under reduced pressure. In the case of conducting under ordinary pressure, the heating can be conducted even in the atmosphere or in the inert atmosphere. In addition, for minute adjustment of an amount of the organic component, the above amine (and carboxylic acid) can be added later.

The bonding composition according to the present embodiment mainly contains metal colloid particles where the metal particles mentioned bellow become colloid as a primary component, but regarding a morphology of such metal colloid particles, for example, metal colloid particles configured by adhering an organic substance onto a portion of surfaces of metal particles, metal colloid particles where their surfaces are coated with an organic component using the above metal particles as a core, metal colloid particles that are configured by mixing these and the like can be exemplified, but it is not particularly limited. Among them, the metal colloid particles where their surfaces are coated with the organic component using the metal particles as a core are preferable. One skilled in the art can arbitrarily prepare metal colloid particles having the morphology using a known technology in the field.

The bonding composition according to the present embodiment is a fluent material that contains the inorganic particles as a main component and the organic component as a side component, and other than these, may contain a dispersion medium, a residual reducing agent, and the like.

The viscosity of the bonding composition of the present embodiment should be arbitrarily adjusted within a range not impairing the effects of the present invention, and for example, it should be within the viscosity range of 0.01 to 5000 Pa ·S, and the viscosity range of 0.1 to 1,000 Pa ·S is more preferable, and the viscosity range of 1 to 100 Pa ·S is particularly preferable. The adjustment within the viscosity ranges above enables the application of a broad method as a method for applying a composition for bonding onto the substrate.

As a method for applying the bonding composition onto the substrate, any method can be arbitrarily selected and adopted, for example, from a dipping, a screen printing, a spray method, a barcode method, a spin-coating method, an inkjet method, a dispenser method, an application method by a brush, a casting method, a flexo method, a gravure method, an offset method, a transfer method, a hydrophilic/hydrophobic method and a syringe method and the like.

The viscosity can be adjusted by adjustment of the particle size of the metal particles, adjustment of content of an organic substance, adjustment of additive amounts of a dispersion medium and other components, adjustment of a blending ratio of each component, addition of thickener and the like. The viscosity of the bonding composition can be measured, for example, with a cone-plate viscometer (for example, Leometer MCR301 manufactured by AntonPaar).

(1-3) Mass loss ratio of inorganic particles

A mass loss ratio due to the organic component and the inorganic component which adhere on the surface of the metal particles used as the inorganic particles of the bonding composition according to the present invention is preferably less than 25 % by mass, more preferably less than 20 % by mass. Specifically, when heating the bonding composition from a room temperature to 500°C at a temperature elevating rate of 10 °C/min in an atmospheric circumstance, a heat loss is preferably less than 25 % by mass, more preferably less than 20 % by mass. When the mass loss ratio is less than 25 % by mass, an amount of the component to protect the surface of the metal particles becomes small, each of the metal particles can easily be sintered and fused.

A surface of metal particle is usually covered with an additive such as a lubricant, a dispersant and an anti-rust agent, and a part of the surface is oxidized or sulfureted. Though a noble metal is relatively not oxidized, it is difficult to inhibit the oxidization completely, and for example, even a case of silver, a part of the surface is oxidized or sulfureted (adhesion of inorganic component).

The above organic component and the inorganic component cause the lowering of the bonding strength, and thus are not preferable. By setting the mass loss ratio, when heating the bonding composition from a room temperature to 500°C at a temperature elevating rate of 10 °C/min in an atmospheric circumstance, at less than 20 % by mass to reduce the organic component and the inorganic component adhered on the surface of the metal particles, since the organic component and the inorganic component remained in the bonding layer after the bonding process, it is possible to improve the reliability of the bonding portion at a high temperature.

The metal particles cam be produced, for example, by mixing a source of metal ion and a dispersant, and then reducing. In this case, by optimizing amounts of added dispersant and a reducing agent, or the like, it is possible to control the amount of the organic component. As metal particles which may be added to the metal particles of nano meter size, a commercially available metal powder with a micron meter or a sub-micron meter size may also be used.

In order to regulate an effective amount of the metal particles, there may be used a heat treatment to the metal particles, a washing by an acid (sulfuric acid, hydrochloric acid, and nitric acid, etc.), a washing by a fat-soluble organic solvent such as acetone or methanol, and the like. In addition, during the washing, by applying an ultrasonic wave, the organic component can be remover more efficiently.

(1-4) Sulfur content of bonding composition

The sulfur content in the bonding composition of the present invention is 10 % by atom or less relative to the total amount of the inorganic particle and the organic component.

As mentioned above, the sulfur tends to react with the inorganic particles to form sulfur compound on the surface of the inorganic particle. Since the sulfur compound formed on the surface of the inorganic particle may inhibit the sintering and fusion of the inorganic particles with each other at the sintering (bonding), it is not preferable from viewpoints of the high shear strength and long-term reliability of the bonding body. Particularly, since the silver has a high standard oxidation-reduction potential of 0.8 V to form a sulfide compound readily, and when the metal particles are silver particles, a silver sulfide coating layer is formed on the surface of the silver particle which composed the bonding composition.

It is necessary to consider sulfur which enters from the atmosphere into the bonding composition in addition to the sulfur initially contained in the components of the bonding composition. Specifically, in the step of heat bonding for forming the bonding body, there is a case that sulfur derived from hydrogen sulfide and sulfurous acid gas in the atmosphere may be remained in the bonding layer. In such a circumstance, the metal particles used as the inorganic particles is prevented from the sintering and fusion of each other, the high shear strength and long-term reliability of the bonding body is lowered.

Here, when the sulfur content relative to the total amount of the inorganic particle and the sulfur in the bonding composition is 10 % by atom or less, the above formation of the sulfur compound can be inhibited, and thus, by inhibiting the sulfide compound, the high shear strength and long-term reliability of the bonding body can be improved. The sulfur content is preferably 8 % by atom, more preferably 4 % by atom or less. In general, a thiol-based organic substance is often used as a dispersant for silver nano particles or gold nano particles. In such a case, for example, when using the dispersant of $HS-C_4H_{10}$ is used as the organic substance, and including the organic substance in an amount of 20 % by mass, the sulfur content is 22 % by atom.

The sulfur content in the bonding composition and the amount of atoms of the element which compose the inorganic particle can be measured by using, for example, the XPS (X-ray Photoelectron Spectroscopy).

(2) Production of bonding composition

In order to produce the bonding composition according to the present embodiment, it is necessary to prepare the inorganic particles which is covered with the organic component as the main components and mixed with the other components, and further to control the amount of the sulfur contained in the bonding composition.

The methods for regulating the amount of the organic component and the weight loss are not particularly limited, and an easy method is to regulate by heating. Also, the regulation may be conducted by regulating an amount of the added organic component at the preparation of the metal particles, or may be regulated by changing the washing conditions and the number of washings after preparation of the metal particles. The heating can be carried out by an oven, an evaporator, or the like. The heating temperature may be the range of from about 50 to 300°C, and the heating time may be several minutes to several hours. The heating may be carried out under a reduced pressure. By heating under a reduced pressure, the regulation of the amount of the organic material can be conducted at a lower temperature. When carrying out under a normal pressure, the regulation can be conducted in the atmosphere or in an inert atmosphere. Further, in order to regulate the amount of the organic material sensitively, an amine or a carboxylic acid may be added later.

A method for preparing the metal particles coated with the organic component of the present invention is not particularly limited, and, for example, there is employed a method where preparing a dispersion which contains the metal particles, and subsequently, washing the dispersion. A process step for preparing the dispersion which contains the metal particles is, for example, in the followings, a process where metal salt (or metal ions) dissolved into a solvent should be reduced, and as reduction procedures, a procedure based upon a chemical reduction method should be adopted.

Namely, the metal particles coated with the above organic component can be prepared by reducing a raw material liquid (a part of the component may not be dissolved but may be dispersed) which contains the metal salt of metal constituting metal particles, an organic substance as the dispersant and a solvent (basically, an organic system such as toluene, but water may be contained).

As a result of the reduction, the metal colloid particles where the organic component as the dispersant is adhered onto at least a port of surfaces of the metal particles are obtained. The metal colloid particles can be supplied as the composition for metal bonding as it is, and also may be supplied by mixing with the metal particles of micron meter or submicron meter.

As a starting material in order to obtain the metal particles coated with the organic substance, various known metal salts or their hydrate can be used, and examples include a silver salt such as silver nitrate, silver sulfate, silver chloride, silver oxide, silver acetate, silver oxalate, silver formate, silver nitrite, silver chlorate or silver sulfide; a gold salt such as chlorauric acid or gold potassium chloride, gold sodium chloride;; a platinum salt such as chloroplatinic acid, platinum chloride, platinum oxide or potassium chloroplatinate; a palladium salt such as palladium nitrate, palladium acetate, palladium chloride, palladium oxide or palladium suphate; and the like, but are not limited thereto as long as it can be dissolved into an appropriate solvent and can be reduced. Further, these can be used alone or in combination of two or more.

Further, the method to reduce the metal salts in the raw material liquid is not particularly limited, and example include a method by using a reducing agent, a method by irradiating a light such as ultraviolet rays, electron beams, ultrasonic waves or thermal energy, and the like. Among these, from a viewpoint of easy operation, the method by using the reducing agent is preferable.

Examples of the reducing agent include an amine compound such as dimethylaminoethanol, methyldiethanolamine, triethanolamine, phenidone or hydrazine; a hydrogen compound such as sodium boron hydride, hydrogen iodide or hydrogen gas; an oxide such as carbon monoxide, sulfurous acid; a low-valent metal salt such as ferrous sulfate, ferric oxide, ferric dumarate, ferrous lactate, ferric oxalate, ferric sulfide, tin acetate, tin chloride, tin diphosphate, tin oxalate, tin oxide or tin sulfate; a sugar such as ethylene glycol, glycerin, formaldehyde, hydroquinone, pyrogallol, tannin, tannic acid, salicylic acid or D-glucose; and the like, but are not limited thereto as long as it can be dissolved into an appropriate solvent and can be reduced. In case of using the above reducing agent, reduction reaction can be accelerated by adding light and/or heat.

As a specific method for preparing the metal particles coated with the organic substance by using the metal salt, the organic component, the solvent and the reducing agent, examples include a method where dissolving the metal salt into an organic solvent (for example, toluene and the like) to prepare a solution of the metal salt, and adding an organic substance as the dispersant to the solution of the metal salt, and then gradually adding dropwise the solution where the reducing agent is dissolved, and the like.

In the dispersion containing the metal particles coated with the organic component as the dispersant obtained in the above mentioned manner, an electrolyte concentration of the entire dispersion tends to be higher, because there are counter ions of metal salt, a residue of the reducing agent and the dispersant other than the metal particles. Since the dispersion in such a condition has a high conductivity, the metal particles tend to be coagulated and easy to be deposited. Alternatively, even if the metal particles liquid is not deposited, when the counter ions of the metal salt, a residue of the reducing agent or the dispersant in an amount of excess to the necessary amount for dispersing remains, three is a risk to make the conductivity worse. Then, the metal particles coated with the organic substance can be surely obtained by washing the solution containing the metal particles to remove the excess residues.

As the washing method, example include a method where steps for allowing to stand the dispersion containing the metal particles coated with the organic component for a certain period of time, and adding an alcohol (such as methanol) for stirring again after the generated supernatant is removed, and further allowing to stand the mixture for a certain period of time and then removing the generated supernatant are repeated several times; a method where centrifugal separation is conducted instead of the above standing; a method where desaltation by using ultrafiltration equipment, ion exchange equipment or the like. The metal particles coated with the organic component of the present embodiment can be obtained by such washing for removing the organic solvent.

The metal colloid dispersion is obtained by mixing the metal particles coated with the organic component obtained above and the dispersion medium explained in the embodiment above. The method for mixing the metal particle coated with the organic component and the dispersion medium is not particularly limited, and can be conducted according to the conventional known method by using an agitator or a stirrer. The mixture may be stirred by using a spatula or the like, or thereto an appropriate output of ultrasonic homogenizer may be irradiated.

When obtaining the metal colloid dispersion containing a plurality of metals, the manufacturing method is not particularly limited, and ,when manufacturing the metal colloid dispersion made of silver and other metal, in the preparation procedures of the metal particles coated with the organic substance, a dispersion containing the metal particles and other dispersion containing the other metal particles are separately prepared, and then to be mixed, or a silver ion solution and other metal ion solution may be mixed and then reduced.

The organic component contained in the bonding composition and its amount can be confirmed by measurement by using, for example, TG-DTA/GC-MS available from Rigaku Corporation. The measuring conditions may be optionally adjusted, and for example, the TG-DTA/GC-MS measurement may be carried out at the time when maintaining a sample of 10 mg from a room temperature to 550°C in the atmosphere (temperature elevating rate 10 °C/min).

Solid particles can be obtained by washing the metal particles with methanol, centrifuging (for example, 3300 rpm fir 2 minutes) to precipitate again, removing the supernatant liquid, and then drying under a reduced pressure. By subjecting the obtained the solid particles to the TG-DTA/GC-MS measurement, the organic component adhered on the surface of the metal particles and its amount can be determined.

Further, when the bonding composition obtained according to the above process is restored together with a sulfur adsorbent, it is possible to decrease the amount of sulfur in the bonding composition. The sulfur adsorbent is not particularly limited, and examples include an active carbon, a metal oxide, potassium, calcium, vanadium, manganese, nickel, copper, zinc, and the like. The metal oxide may be combined with at least one of appropriate binders selected from the group consisting of clay, graphite, alumina, silica, magnesia, chromia, and boria. In addition, a commercially available sulfur adsorbent such as Purafil Puracarb (available from Purafil Co., Ltd.) or KNK-301 (available from Kurehayushi Kogyo Co., Ltd.)

Specifically, for example, the sulfur adsorbent KNK-301 (available from Kurehayushi Kogyo Co., Ltd., zinc oxide-based chemical adsorbent, shape: spherical, relative surface area: 50 $m^2$/g, bulk density: 1.17 g/ml, pellet diameter: 3 mm) or a sulfur compound-adsorbing type zeolite, or the like is put in a sealing vessel, and the bonding composition of the present invention is put in, for example, an ointment jar. Then, the ointment jar while the rid is opened is put in the sealing vessel to coexist the bonding composition and the sulfur adsorbent.

(3) Bonding method

When using the bonding composition according to the present embodiment, the high shear strength and long-term reliability can be obtained in the bonding of members with heating. Here, the long-term reliability means that the mechanical properties, and the like of the bonded body can be maintained for a long period of time, and, for example, means that, even after applying heat cycle many times, the mechanical properties, and the like of the bonded body cannot be easily lowered.

According to one example of the bonding method by using the bonding composition according to the present embodiment, a first metal body as the first member to be bonded and a second metal body as the second member to be bonded can be bonded by a step for applying the bonding composition where the bonding composition is applied between the first metal body and the second metal body, and a bonding step where the bonding composition applied between the first metal body and the second metal body is sintered at a desired temperature (for example, 300°C or less, preferably between 150 and 200°C) to bond (form the bonding layer). In this case, a pressure may be added, but a sufficient bonding strength can be obtained without a particular additional pressure, this is one of the advantages of the present invention. Further, when sintering, temperature can be increased and decreased in stepwise. Further, it is also possible to previously apply a surfactant, a surface activating agent or the like on surfaces of the members to be bonded.

The inventor of the present invention, as a result of intensive study, has found that the first metal body and the second metal body can be more surely bonded with a high bonding strength and the long-term reliability can be obtained when using the bonding composition according to the present embodiment mentioned above as the bonding composition in the step for applying the bonding composition.

Herein, "application" of the bonding composition of the present embodiment is a concept including both a case of planarly applying and another case of linearly applying (drawing) the bonding composition. It is possible that the configuration of a coating film made of the bonding composition in the state before applying and sintering by heating is desired one. Therefore, in the bonded body of the present embodiment after sintering by heating, the bonding composition is a concept including both a planar bonding layer and a linear bonding layer, and these planar bonding layer and linear bonding layer may be continuous or discontinuous, or may include a continuous portion and a discontinuous portion.

As the first metal body and the second metal body that are usable in the present embodiment, they should be ones where the bonding composition is applied, and that are sintered and bonded by heating, and there is no particular limitation, but members having a thermal resistance to the extent of not damaging at a temperature upon bonding are preferable.

Many materials can be used as the materials constituting such metal body. The reason why the metal body is preferable is that it is excellent in thermal resistance, and, it is excellent in affinity with the bonding composition of the present invention where inorganic particles are metal.

Further, the members to be bonded may be various shapes, such as plate-like or strip-like, and it may be rigid or flexible. Thickness of the substrate may also be optionally selected. For improvement of adherence property or adhesiveness or other purpose, a member where a surface layer is formed, or a member where surface treatment such as hydrophilic treatment is carried out may be used.

In the process to apply the bonding composition onto the members to be bonded, it is possible to use various methods, and as described above, it is possible to employ optionally a method selected among dipping, screen print, a spray method, a barcode method, a spin-coating method, an inkjet method, a dispenser method, a pin-transferring method, an application method by a brush, a casting method, a flexo method, a gravure method, and a syringe method.

The coating film after being applied as mentioned above is sintered by heating at, for example, 300°C or less within the range that does not damage the members to be bonded, and the bonded body of the present embodiment can be obtained. In the present embodiment, as mentioned above, because the bonding composition of the present embodiment is used, the bonding layer having superior adhesiveness with regard to the members to be bonded can be obtained, and a strong bonding strength can be more surely obtained.

In the present embodiment, when the bonding composition contains a binder component, from viewpoints to improve strength of the bonding layer and improvement of bonding strength between the members to be bonded, the binder component is also baked, but depending upon circumstances, a baking condition is controlled and the binder component may be removed all with adjustment of the viscosity of the bonding composition for applying to various printing methods as a primary purpose of the binder component.

The method for sintering is not particularly limited, but for example, the members to be bonded can be bonded by sintering so as to adjust the temperature of the bonding composition applied or drawn on the members to be bonded, for example, at 300°C or less, for example, by using a conventionally known oven or the like. The lower limit of the temperature for sintering is not necessarily limited, and it is preferable that it is a temperature than can made bonding of the members to be bonded, and, it is a temperature within the range that does not impair the effect of the present invention. Herein, in the bonding composition after sintering above, from a point to obtain greater bonding strength as much as possible, the lesser a residue of the organic substance is, the better, but a portion of the organic substance may remain within the scope that does not impair the effect of the present invention.

Furthermore, the bonding composition of the present invention contains the organic substance, but unlike the conventional one utilizing thermal-setting such as epoxy resin, it does not obtain the bonding strength after sintering due to action of the organic substance, but it obtains sufficient bonding strength by fusion of the fused metal particles. Consequently, after bonding, even if the bonding composition is placed in such an environment to be used that a temperature is higher than a bonding temperature, and the residual organic substance is deteriorated or decomposed to be disappeared, the bonding strength will never be decreased, therefore, it is excellent in the thermal resistance.

According to the bonding composition of the present embodiment, since bonding having a bonding layer developing a high conductivity can be realized, even with sintering by heating at a low temperature, for example, at around 150 to 200°C, the members to be bonded which comparatively weak to heat, can be bonded. Further, a sintering time is not particularly limited, and it should be a sintering time for enabling to bond the members at the sintering temperature.

In the present embodiment, in order to further enhance the adhesiveness with the members to be bonded and the bonding layer, the surface treatment of the members to be bonded may be conducted. Examples of the surface treatment include a dry treatment such as corona treatment, plasma treatment, UV treatment or electron beam treatment; a method where a primer layer and a conductive paste receptive layer is previously formed on the substrate; and the like.

In the metal bonded body of the present invention, the sulfur content contained in the bonding layer is 15 % by atom or less, preferably 9 % by atom. Here, the sulfur content of the bonding layer can be suitably decreased by using the bonding composition of the present invention, and, when the sulfur content of the bonding layer is more than 15 % by mass even by using the bonding composition of the present invention, the sulfur content of the bonding layer can be decreased by coexisting the above sulfur adsorbent at the sintering with heat. The sulfur content of the bonding layer can be measured by using, for example, the XPS (X-ray Photoelectron Spectroscopy) as in the bonding composition.

As the method for coexist of the sulfur adsorbent at the sintering, there is a method described herein below. Specifically, for example, the bonding composition is applied to an alumina plate having gold plating on the surface thereof in a small amount, and thereon, an alumina plate having gold plating on the surface thereof is laminated to fabricate a laminated article of a sample. Further, for example, the sulfur adsorbent KNK-301 or the sulfur compound-adsorbing type zeolite is put in a vat of aluminum. Next, the above laminated article is put in the vat of aluminum, and these sulfur adsorbent and the laminated article are accommodated in a hot air circulating type oven. The hot air circulating type oven is previously heated before the accommodation of the sulfur adsorbent and the sample to regulate its temperature, the sintering treatment is conducted under the desired sintering condition.

In the above, the typical embodiments of the present invention are explained, but the present invention is not be limited thereto. For example, in the embodiments above, the metal colloid dispersion where metal particles have been employed as the inorganic particles is explained, and for example, inorganic particles such as tin-doped indium, alumina, barium titanate or iron lithium phosphate, excelling in, for example, conductivity, thermal conductivity, dielectricity, ion conductivity or the like, can also be used.

EAXMPLE

In the following, in Examples and Comparative Examples, the bonding composition and the metal bonded body using the compound of the present invention are further explained, but the present invention is not limited to these examples at all.

«Example 1»

200 mL of toluene and 15 g of an amine (hexylamine) were mixed and sufficiently stirred with a magnetic stirrer. While stirring, 10 g of silver nitrate was added, and after dissolving the silver nitrate, 15 g of carboxylic acids (5 g of oleic acid and 10 g of hexanoic acid in this order) were added to obtain a toluene solution of silver nitrate. A 0.02 g/mL of sodium borohydride solution prepared by adding 1 g of sodium borohydride into 50 mL of ion-exchanged water was added dropwise to the toluene solution of silver nitrate, and then a dispersion containing silver fine particles having an average particle size of 22 nm was obtained. The particle size of the silver particles was measured by the above wide-angle X-ray diffraction method. The materials used herein were previously stored within a nitrogen atmosphere where the sulfur adsorbent was present, and the synthesis was carried out in a glove box (within a nitrogen atmosphere where the sulfur adsorbent was present).

After stirring the dispersion containing silver fine particles for one hour, 200 mL of methanol was added, and the silver fine particles were coagulated and precipitated. In addition, after the silver particles were completely precipitated with centrifugal separation, toluene and methanol which were supernatants, were removed and excess organic substances were removed by decantation. Further toluene was added to the remaining precipitate to disperse the silver fine particles, and methanol was added again. Repeating these procedures, and finally, toluene and methanol were removed, and the excess organic substances were removed to obtain approximately 6 g of the silver fine particles. 1.3 g of tetradecane (special grade chemicals available from Wako Pure Chemical Industries, Ltd.) was added as the dispersant to the thus obtained 6 g of silver fine particles and stirred to obtain the bonding composition.

Next, the obtained bonding composition was stored in a sealing vessel together with 1 g of a sulfur adsorbent (sulfur compound-adsorbing type zeolite) for 24 hours to obtain a bonding composition of the present invention. Specifically, the sulfur compound-adsorbing type zeolite was put in a High Vessel (available from AS ONE Corporation, volume: 325 ml, model number: No. 300) as the sealing vessel. Subsequently, approximately 7.3 g of the bonding composition was put in an ointment jar (available from Yamayu, volume: 12 ml, model number: No. 3-52). Then, the ointment jar while the rid was opened was put in the sealing vessel to coexist the bonding composition and the sulfur adsorbent under the conditions of coexisting time: 24 hours, and coexisting temperature: 22°C.

The thus obtained bonding composition was applied by a die bonder (available from HiSOL, Inc.) to an alumina plate (area of 50 mm x 50 mm) having gold plating on the surface thereof in a small amount, and thereon, an alumina plate (area of 1 mm x 1 mm) having gold plating on the surface thereof is laminated. After that, the laminated article and 1 g of the sulfur adsorbent (sulfur compound-adsorbing type zeolite) were put in a hot air circulating type oven (available from Advantec Toyo Kaisha Ltd., model type: DRM320DB, inner size: W310 mm x D300 mm x H300 mm) regulated at 250°C, was subjected to the heat sintering treatment under an atmospheric circumstance for 120 minutes to obtain a metal bonded body. The bonding compositions and the metal bonded bodies were evaluated according to various tests, and the results are shown in Table 1.

[Evaluation tests]

(1) Measurement of mass loss ratio

The mass loss ratio of the thus obtained bonding composition is calculated by a dry weight method. With respect to the obtained bonding composition, when heating from a room temperature to 500°C at a temperature elevating rate of 10 °C/min in a nitrogen atmosphere, a change of heat loss was measured by using TG/DTA300 available from Seiko Instrument Inc., and the mass loss of from 100°C to 500°C was calculated.

(2) Quantitative analysis of sulfur content

The sulfur contents, and the like of the thus obtained bonding composition and the metal bonded body (bonding layer) were measured by the XPS (X-ray photoelectron spectroscopy). According to the present example, since the inorganic particle was silver particle, the sulfur content was calculated according to the following equation.

$$\text{Sulfur content (atomic \%)} = \text{Sulfur atomic weight} / (\text{Sulfur atomic weight} + \text{Silver atomic weight}) \times 100$$

The followings were the measuring apparatus and measuring conditions.

- Measuring apparatus: ULVAC PHI 5000 Versa Probell
- X-ray irradiation condition: AlKα beam (1486.6 eV), φ 100 μm, 25 W, 15 KeV, angle of inclination 45 degrees
- Analyzing pass energy: wide range (W) hour 117.4 eV, narrow range (N)hour 11.75 eV
- Cumulative number: 10
- Repeating number: 1
- Analysis area: 100 μm square (scanning)
- Spatter: argon ion 4 kV, area 2 x 2 mm, rate 3.6 nm/min for 20 min.

(3) Shearing strength test

After the above obtained metal bonded body was taken out from the hot air circulating type oven and cooled, the shearing strength test at normal temperature was conducted by using Bondtester (available from RHESCA Corporation). When the type of breakage mode is the cohesive failure of the bonding layer, the evaluation is (×), and when being the material failure, the evaluation is (○). The shearing strength is preferably 10 to 100 MPa. In the cohesive failure, the bonding layer was primarily broken because the sintering and fusion of the bonding material were poor, but in the material failure, the member to be bonded was primarily broken, which means that the bonding material was sintered densely to form a strong bonding layer. Namely, the material failure is preferable in view of high bonding strength in comparison with the cohesive failure.

(4) Long-term reliability test (heat cycle test)

After the above obtained metal bonded body was taken out from the hot air circulating type oven and cooled, the body was put in a hot-cold shock testing apparatus (TSA-41L available from ESPEC CORP.), and subjected to the heat cycle where the higher temperature side: 125°C for 30 min., the lower temperature side: - 40°C for 30 min. One exposure to the higher temperature and the lower temperature is assumed to be one cycle, the shearing strengths after 200 cycles, 500 cycles, 1000 cycles and 2000 cycles were measured (Shearing strength testing rule: MIL STD-883G). Accounting the number of cycles at which the shearing strength became failure, in case of less than 500 cycles is evaluated as (×), in case of 500 or more is evaluated as (○), in case of 1000 or more is evaluated as (◎).

«Examples 2 and 3»

The same procedures as in Example 1 were repeated except that a bonding composition was prepared so that the mass loss ratio was 5 % by mass or 22 % by mass by regulating the amount of tetradecane to obtain bonding compositions and metal bonded bodies. Further, the same evaluation tests as in Example 1 were conducted. The results are shown in Table 1.

«Examples 4 to 6»

The same procedures as in Examples 1 to 3 were repeated except that the sulfur adsorbent (sulfur compound-adsorbing type zeolite) was not present together with the bonding composition at the heat sintering to obtain bonding compositions and metal bonded bodies. Further, the same evaluation tests as in Example 1 were conducted. The results are shown in Table 1.

«Comparative Examples 1 and 2»

The same procedures as in Examples 2 and 3 were repeated except that the bonding composition was not stored together with the sulfur adsorbent (sulfur compound-adsorbing type zeolite) to obtain bonding compositions and metal bonded bodies. Further, the same evaluation tests as in Example 1 were conducted. The results are shown in Table 1.

«Comparative Examples 3 to 5»

The same procedures as in Examples 1 to 3 were repeated except that the bonding composition was not stored together with the sulfur adsorbent (sulfur compound-adsorbing type zeolite) and that the sulfur adsorbent (sulfur compound-adsorbing type zeolite) was not present together with the bonding composition at the heat sintering to obtain bonding compositions and metal bonded bodies. Further, the same evaluation tests as in Example 1 were conducted. The results are shown in Table 1.

[Table 1]

| | | EXAMPLE | | | | | | COMPARATIVE EXAMPLE | | | | |
|---|---|---|---|---|---|---|---|---|---|---|---|---|
| | | 1 | 2 | 3 | 4 | 5 | 6 | 1 | 2 | 3 | 4 | 5 |
| Mass loss ratio of bonding composition | % by mass | 18 | 5 | 22 | 18 | 5 | 22 | 5 | 22 | 5 | 18 | 22 |
| Presence or absence of sulfur adsorbent (Storage) | · | Presence | Presence | Presence | Presence | Presence | Presence | Absence | Absence | Absence | Absence | Absence |
| Presence or absence of sulfur adsorbent (Sintering) | · | Presence | Presence | Presence | Absence | Absence | Absence | Presence | Presence | Absence | Absence | Absence |
| Sulfur content in bonding composition | % by atom | 1.7 | 2.3 | 3.2 | 7.4 | 6.4 | 6.1 | 14.2 | 15.5 | 13.3 | 14.3 | 16.8 |
| Sulfur content in bonding layer | % by atom | 4.0 | 8.6 | 7.4 | 11.5 | 12.8 | 12.5 | 15.5 | 19.6 | 15.5 | 19.5 | 18.8 |
| Shear strength | MPa | 60.7 | 29.9 | 30 | 20.3 | 17.2 | 16.9 | 14 | 16.7 | 14.6 | 16.2 | 18.5 |
| | Breakage mode | Material failure | Material failure | Material failure | Material failure | Material failure | Material failure | Cohesive failure | Cohesive failure | Cohesive failure | Cohesive failure | Cohesive failure |
| | Decision | ○ | ○ | ○ | ○ | ○ | ○ | X | X | X | X | X |

(continued)

| | | EXAMPLE | | | | | | COMPARATIVE EXAMPLE | | | | |
|---|---|---|---|---|---|---|---|---|---|---|---|---|
| | | 1 | 2 | 3 | 4 | 5 | 6 | 1 | 2 | 3 | 4 | 5 |
| Long-term reliability (heat cycle test) | 500 cycles | Material failure | Material failure | Materia] failure | Material failure | Material failure | Material failure | Cohesive failure | Cohesive failure | Cohesive failure | Cohesive failure | Cohesive failure |
| | | ○ | ○ | ○ | ○ | ○ | ○ | X | X | X | X | X |
| | 1000 cycles | Material failure | Cohesive failure | Cohesive failure | Cohesive failure | Cohesive failure | Cohesive failure | Cohesive failure | Cohesive failure | Cohesive failure | Cohesive failure | Cohesive failure |
| | | ○ | X | X | X | X | X | X | X | X | X | X |
| | 2000 cycles | Maternal failure | Cohesive failure | Cohesive failure | Cohesive failure | Cohesive failure | Cohesive failure | Cohesive failure | Cohesive failure | Cohesive failure | Cohesive failure | Cohesive failure |
| | | ○ | X | X | X | X | X | X | X | X | X | X |
| | Decision | ◎ | ○ | ○ | ○ | ○ | ○ | X | X | X | X | X |

As is clear from the results in Table 1, in Example 1, the excellent shear strength and long-term reliability can be ensured by coexisting with the sulfur adsorbent during the storage and heat bonding of the bonding composition to make the sulfur content in the bonding layer of the bonding composition and metal bonded body be 10 % by atom or less.

Further, in Example 2, when preparing the bonding composition having the mass loss ratio of the bonding composition of 5 % by mass, the shear strength and long-term reliability can be ensured as is in Example 1 where the mass loss ration of the solid of the bonding composition is 18 % by mass.

In Example 3, when preparing the bonding composition having the mass loss ratio of the bonding composition of 22 % by mass, the shear strength and long-term reliability can be ensured as is in Example 1 where the mass loss ration of the solid of the bonding composition is 18 % by mass.

In Examples 4 to 6, when the sulfur adsorbent is present in the storage of the bonding composition, but is absent during the sintering, the sulfur content in the bonding composition is 10 % by atom or less. The sulfur content in the bonding layer of the metal composite is 15 % by atom or less, and the excellent shear strength can be exhibited in the similar level of Examples 1 to 3.

In Comparative Examples 1 and 2, when the sulfur adsorbent is present in the sintering (heat bonding), but is absent during the storage of the bonding composition, the sulfur content in the bonding composition and the bonding layer of the metal composite is more than 10 % by atom. The shear strength and long-term reliability are poor in comparison with those in Examples 1 to 6.

In Comparative Examples 3 to 5, when the sulfur adsorbent is absent both in the sintering (heat bonding) and during the storage of the bonding composition, the sulfur content in the bonding composition and the bonding layer of the metal composite is more than 1015 % by atom. The shear strength and long-term reliability are poor in comparison with those in Examples 1 to 6.

**Claims**

1. A bonding composition comprising an inorganic particle and an organic component, wherein a sulfur content in the bonding composition is 10 % by atom or less relative to the total amount of the inorganic particle and the organic component.

2. The bonding composition according to Claim 1, wherein the organic component is adhered at least a part of the surface of the inorganic particle, and the organic component comprises an amine.

3. The bonding composition according to Claim 1 or 2, wherein a mass loss ratio when heating from a room temperature to 500°C at a temperature elevating rate of 10 °C/min in an atmospheric circumstance is less than 25 % by mass.

4. The bonding composition according to Claim 1 or 2, wherein the inorganic particle contains at least one metal selected from the group consisting of gold, silver, copper and platinum.

5. A bonded body which comprises a first member to be bonded, a bonding layer, and a second member to be bonded, the first member to be bonded and the second member to be bonded is bonded by the bonding layer, and the bonding layer is composed of a metal having a sulfur content of 15 % by atom or less.

## INTERNATIONAL SEARCH REPORT

| International application No. |
|---|
| PCT/JP2015/001320 |

### A. CLASSIFICATION OF SUBJECT MATTER

*B22F1/00*(2006.01)i, *B22F1/02*(2006.01)i, *B23K35/30*(2006.01)i, *C04B37/00* (2006.01)n

According to International Patent Classification (IPC) or to both national classification and IPC

### B. FIELDS SEARCHED

Minimum documentation searched (classification system followed by classification symbols)
B22F1/00, B22F1/02, B23K35/30, C04B37/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2013-159830 A (Toyota Central Research and Development Laboratories, Inc.), 19 August 2013 (19.08.2013), paragraphs [0074] to [0125]; fig. 1 to 42 (Family: none) | 1-5 |
| A | JP 2011-068988 A (DOWA Electronics Materials Co., Ltd.), 07 April 2011 (07.04.2011), paragraph [0051] (Family: none) | 1-5 |

☐ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 June 2015 (04.06.15) | 16 June 2015 (16.06.15) |

| Name and mailing address of the ISA/ | Authorized officer |
|---|---|
| Japan Patent Office 3-4-3,Kasumigaseki,Chiyoda-ku, Tokyo 100-8915,Japan | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008063688 A

- JP 2012046779 A